# EUROPEAN PATENT SPECIFICATION

(11) **EP 3 921 878 B1**
(45) Date of publication and mention of the grant of the patent: **08.05.2024**
(21) Application number: 20706111.0
(22) Date of filing: 04.02.2020
(51) Int. Cl.: H10N 30/87, D04B 21/04, H10N 30/30, H10N 30/063

(54) **METHOD FOR MANUFACTURING PIEZOELECTRIC TEXTILE ENERGY HARVESTER AND SENSOR**
VERFAHREN ZUR HERSTELLUNG EINER PIEZOELEKTRISCHEN TEXTILEN ENERGIEGEWINNUNGSEINRICHTUNG UND EINES SENSORS
PROCÉDÉ DE FABRICATION D'UN COLLECTEUR D'ENERGIE ET D'UN CAPTEUR D'ÉNERGIE TEXTILE PIÉZOÉLECTRIQUE

(30) Priority: 04.02.2019 AT 600232019
(43) Date of publication of application: 15.12.2021
(73) Proprietor: V-Trion GmbH Textile Research, 6845 Hohenems (AT)
(72) Inventor: HOSSAIN, Ishtia Zahir, 6845 Hohenems (AT); HOSSAIN, Khondaker Gaffar, 6845 Hohenems (AT); GRABHER, Günter, 6890 Lustenau (AT)
(74) Representative: Schwarz & Partner Patentanwälte GmbH
(86) International application number: PCT/EP2020/052750
(87) International publication number: WO 2020/161134

(56) References cited:
- GB-A- 2 516 987
- KR-B1- 101 401 164
- US-A1- 2018 145 244

## Description

The present invention relates to a piezoelectric textile composite material for harvesting energy via the conversion of mechanical energy into electrical energy and a process for manufacturing said textile.

### Background of the invention

Piezoelectricity is exploited in a number of useful applications including energy harvesting. The piezoelectric effect converts mechanical energy into electric current or voltage. It may come from many different sources like human motion, pressure, movement, low-frequency seismic vibrations, or acoustic noise. Piezoelectric energy harvesting is an emerging technology, which has been investigating only since the late 1990s.

There are efforts to integrate piezoelectric material into clothing to convert the motion from the human body into electrical power. For example, these materials can be embedded in shoes to recover "walking energy".

A way to integrate piezoelectric material into textiles is shown in GB 2 516 987 A. This document discloses an energy-harvesting three-dimensional spacer structure comprising a first and second conductive layer and a piezoelectric spacer material interconnecting the conductive layers in the form of piezoelectric spacer yarns. The piezoelectric spacer material may comprise a polymer (such as PVFD) and is knitted between the conductive layers. The piezoelectric material also may be polarized and the conductive layers have to be either knitted or woven.

### Short description of the invention

The disadvantages of GB 2 516 987 A are on the one hand that it is difficult to produce the energy-harvesting spacer structure due to the knitting or weaving of the material and on the other hand that the contact surface of the piezoelectric material with the conductive material is very small, as they are just knitted together.

Hence, the object of the present invention is to improve the energy-harvesting device described in GB 2 516 987 A in terms of production simplicity and in terms of the properties of the energy-harvester.

A solution to the above mentioned problem is provided by a piezoelectric textile composite material for harvesting energy, which comprises a first layer of electrically conductive textile fabric material, a second layer of electrically conductive textile fabric material and a layer of piezoelectric polymer film comprised between the first and the second electrically conductive textile layers. The piezoelectric polymer film layer is plasma treated and laminated between the first and second electrically conductive textile layer.

In this context, the piezoelectric effect induces an electric current in the textile due to the influence of mechanical stress.

More precisely, a low-pressure plasma treatment for the piezoelectric polymer film layer allows a surface activation to enhance adhesion between the first and second electrically conductive layers and the polymer film layer.

Furthermore, a lamination process allows interconnecting the piezoelectric polymer film layer with the first and second conductive textile layers.

The plasma activation and the lamination process allow for a very good connection of the conductive layers with the piezoelectric polymer film layer. Thus, more charges can be transferred, which makes the energy harvester more effective.

In a preferred embodiment the layer of piezoelectric polymer film of the textile based piezoelectric energy harvesting device and sensor is polarized.

The first and second electrically conductive textile layers comprise any 2D or 3D fabric made of natural or synthetic and woven, knitted, embroidered or non-woven material. Moreover, these layers are preferably coated with conductive material. The coating may be selected from metallic and/or carbon and/or polymeric conductive material, preferably silver, carbon or poly(3,4-ethylenedioxythiophene) polystyrene sulfonate (PEDOT:PSS).

The layer of piezoelectric polymer film comprises material with piezoelectric properties. Preferably, this material comprises a polarized polyvinylidenefluoride (PVDF) film and/or a modified polarized PVDF film. Furthermore, also the piezoelectric layer may be coated with conductive layers based on metal or conductive polymer preferably with carbon, silver and poly(3,4-ethylenedioxythiophene) polystyrene sulfonate.

The textile based piezoelectric energy harvester according to the invention is very thin and flexible. Thus, the textile is comfortable to wear and can be easily integrated within human wearables or any movable, rotating or vibrating device to detect their vibration or movement and simultaneously generate energy from these motions.

The invention also relates to a method for manufacturing a textile based piezoelectric energy harvesting device and sensor. This method comprises a lamination process of the piezoelectric polymer film layer between the first and second electrically conductive textile layers. The temperature in the lamination process is in the range of 70 to 190 °C, preferably 80 to 170 °C, wherein the pressure in the lamination process is 1 to 40 N, preferably 35 to 40 N and the energy input is from 0.5 to 3 kW, preferably from 1 to 2 kW.

The piezoelectric polymer film layer is preferably polarized before the lamination process.

Furthermore, the piezoelectric polymer film layer is treated with a low pressure plasma before the lamination process. More precisely, it is activated with oxygen containing functional groups using a mixture of argon and molecular oxygen at a ratio of 1 to 4, wherein the pressure of the plasma is preferably between 0.1 and 0.5 mbar, wherein the exposure time is preferably between 30 and 600s and the energy input is from 0.5 to 3 kW, preferably from 1 to 2 kW.

The method for producing the energy harvesting device comprises four main steps as summarized below.

In step 1 the conductive textiles, namely the first and second electrically conductive layers, are prepared. For this purpose, either the textile or nonwoven is coated with the conductive material or a knitted or embroidery structure is produced containing a conductive thread.

The next step, step 2, of the method is the activation of the piezoelectric polymer film layer with plasma, as explained above. This is mainly done to increase the adhesion for the next step.

In step 3, the energy harvesting device is completed by laminating the polymer film layer between the first and second layer as described above. An outer protective PU layer is used for the lamination.

In the last step, step 4 several energy conversion techniques may be developed. The device has to be produced in a way such that the mechanical energy in form of movement etc. is converted into electrical energy. For the purpose of converting these AC voltages then into DC voltages a rectifying circuit is integrated in the device. In this last step of the production of the inventive device also means for storing the energy may be provided. Moreover, the device may be configured in such a way that it can be used as a sensor.

Summarizing, the inventive textile based piezoelectric energy-harvesting device comprises embroidery or knitted textile structures as top and bottom electrodes. These conductive layers provide a huge surface area that is in contact with the piezoelectric polymer film surface by vibrations, movement or pressure. The large surface allows generating power easily.

Another advantage of the inventive energy harvester is that it is washable and that it allows for a protection against moisture. The outer shell of the device is a washable

Polyurethane layer. Thus, the device is functioning in any humid environment.

### Detailed description and preferred embodiments

The textile based piezoelectric composite material of the present invention acts as an electrical energy-generating device by means of mechanical action such as movement, deformation, vibration or pressure. When such an external energy is applied to the energy harvesting device the piezoelectric film generates AC voltages, which are converted to DC voltages by a rectifying circuit. This circuit is integrated in the device. The generated DC voltages may then be read out by an oscilloscope.

The foregoing and other objects, features and advantages of the invention will become more apparent from the following detailed description, which proceeds with reference to the accompanying figures.

Fig. 1 shows the three layers of the inventive composite piezoelectric textile with an oscilloscope measuring the generated voltages.

Fig. 2 shows the layers of the inventive piezoelectric textile including conductive coatings on both sides of the piezoelectric layer.

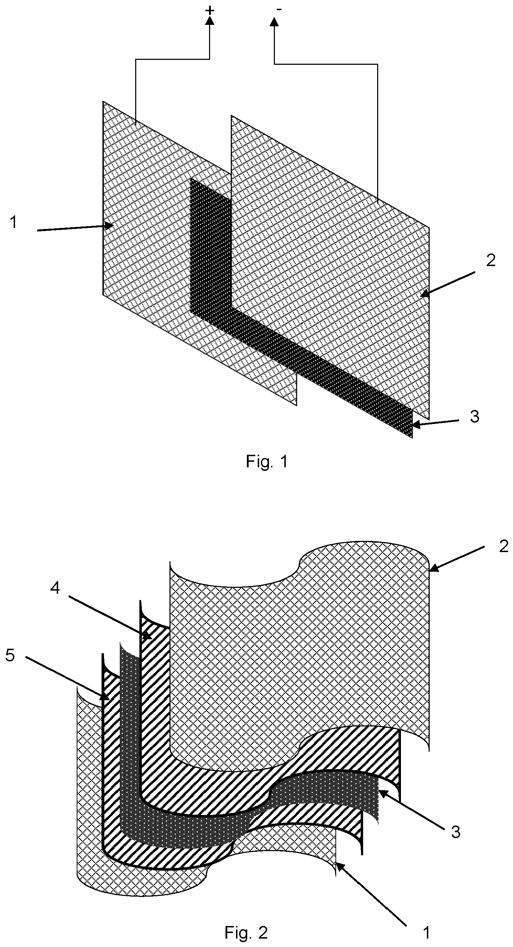

Fig. 1 depicts the textile based piezoelectric energy harvesting device and sensor comprises a first layer 1 of electrically conductive textile fabric material, a second layer 2 of electrically conductive textile fabric material and a layer of piezoelectric polymer film 3 laminated between the first 1 and the second 2 electrically conductive textile layers.

The piezoelectric polymer film layer 3 may have conductive layers 4, 5 at each side as shown in Fig. 2. After coating the piezoelectric polymer film layer 3 with the conductive layers 4, 5 it may be laminated between the first 1 and second 2 electrically conductive textile layers.

An important advantage of the inventive energy harvester is that any conductive material can be used for the conductive layers 4, 5. The textile material may be a weaved, knitted, embroidery or nonwoven structure. One can use these various structures due to the fact that the piezoelectric polymer film layer 3 is laminated between the conductive layers 4, 5. Furthermore, the lamination step simplifies the production of the energy harvester.

In order to enhance adhesion of the layers in the lamination process, the surface of the layer of piezoelectric polymer film 3 is activated beforehand. The surface activation is done by a low-pressure plasma treatment.

A big advantage of the so produced energy harvester is that is washable and very durable. Thus, it can be easily integrated into clothing to generate energy from human movement. This is especially effective if it is integrated into sports clothing. Moreover, these energy generating textiles may also be used in the context of smart-textiles and textiles used for healthcare, where the generated electrical power may be used immediately.

The inventive self-powering sensors can find their applications also in the transport sector including transport on water, on roads and in the air. In all these applications the important properties of the inventive energy harvester - namely flexibility, wearability, washability and comfortability - are mandatory. At the same time the energy harvester is very effective in producing energy out of external energy from the ambient environment due to the strong coupling between the piezoelectric polymer film layer and the conductive textile layers. This strong coupling is achieved via the above described plasma treatment of the piezoelectric layer and the subsequent lamination process of the piezoelectric layer with the conductive layers.

## Claims

1. Energy harvesting device comprising:
- a first layer (1) of electrically conductive textile fabric material,
- a second layer (2) of electrically conductive textile fabric material,
- a layer of piezoelectric polymer film (3) arranged between the first (1) and the second (2) electrically conductive textile layers,
wherein the piezoelectric polymer film layer (3) is laminated between the first (1) and second (2) electrically conductive textile layer by using an outer protective Polyurethane (PU) layer.

2. Energy harvesting device according to claim 1, **characterized in that** the layer of piezoelectric polymer film (3) is polarized.

3. Energy harvesting device according to claim 1 or 2, wherein the piezoelectric polymer film layer (3) is plasma treated.

4. Energy harvesting device according to one of claims 1 to 3, wherein the first (1) and second (2) electrically conductive textile layers comprise any 2D or 3D fabric made of natural fiber or synthetic fiber with woven, knitted, embroidered or non-woven structure.

5. Energy harvesting device according to claim 4, wherein the natural or synthetic material of the first (1) and second (2) electrically conductive textile layers is coated with conductive material, wherein the coating is selected from metallic and/or carbon and/or polymeric conductive material, preferably silver, carbon or poly(3,4-ethylenedioxythiophene) polystyrene sulfonate (PEDOT:PSS).

6. Energy harvesting device according to one of claims 1 to 5, wherein the layer of piezoelectric polymer film (3) comprises material with piezoelectric properties, wherein the material comprises a polarized polyvinylidenefluoride (PVDF) film and/or a modified polarized PVDF film.

7. Energy harvesting device according to claim 6, wherein the piezoelectric material of the piezoelectric polymer film layer (3) is coated with conductive layers based on metal or conductive polymer preferably with carbon, silver and poly(3,4-ethylenedioxythiophene) polystyrene sulfonate.

8. Sensor comprising an energy harvesting device according to one of claims 1 to 7.

9. Method for manufacturing an energy harvesting device and sensor comprising the steps
• preparing a first (1) and second (2) electrically conductive textile layer by either coating a textile or nonwoven with conductive material or producing a knitted or embroidery structure with a conductive thread,
• activating a piezoelectric polymer film layer (3) with plasma,
• laminating the piezoelectric polymer film layer (3) between the first (1) and second (2) electrically conductive layer, wherein the piezoelectric polymer film layer (3) is polarized before the lamination process
• and integrating a rectifying circuit in the device.

10. Method according to claim 9, wherein the temperature in the lamination process of the piezoelectric polymer film layer (3) between the first (1) and second (2) electrically conductive textile layers is in the range of 70 to 190 °C, preferably 80 to 170°C, wherein the pressure in the lamination process is 1 to 40 N, preferably 30 to 40 N, wherein the energy input is from 0,5 to 3 kW, preferably from 1 to 2 kW.

11. Method according to claim 9 or claim 10, wherein the activation is done with a low pressure plasma, wherein it is activated with oxygen containing functional groups using a mixture of argon and molecular oxygen at a ratio of 1 to 4, wherein the pressure of the plasma is preferably between 0.1 and 0.5 mbar, wherein the exposure time is preferably between 30 and 600 s.

## Patentansprüche

1. Energiegewinnungsvorrichtung, umfassend:
- eine erste Schicht (1) aus einem elektrisch leitenden Textilgewebematerial,
- eine zweite Schicht (2) aus einem elektrischen leitenden Textilgewebematerial,
- eine Schicht aus einem piezoelektrischen Polymerfilm (3), der zwischen der ersten (1) und der zweiten (2) elektrischen leitenden Textilschicht angeordnet ist,
wobei die piezoelektrische Polymerfilmschicht (3) unter Verwendung einer äußeren schützenden Polyurethan- (PU-) Schicht zwischen der ersten (1) und der zweiten (2) elektrischen leitenden Textilschicht laminiert ist.

2. Energiegewinnungsvorrichtung nach Anspruch 1, **dadurch gekennzeichnet, dass** die Schicht aus einem piezoelektrischen Polymerfilm (3) polarisiert ist.

3. Energiegewinnungsvorrichtung nach Anspruch 1 oder 2, wobei die piezoelektrische Polymerfilmschicht (3) plasmabehandelt ist.

4. Energiegewinnungsvorrichtung nach einem der Ansprüche 1 bis 3, wobei die erste (1) und die zweite (2) elektrisch leitende Textilschicht ein beliebiges 2D- oder 3D-Gewebe aus Naturfasern oder Kunstfasern mit einer gewebten, gestrickten, gestickten oder Vliesstruktur umfassen.

5. Energiegewinnungsvorrichtung nach Anspruch 4, wobei das natürliche oder künstliche Material der ersten (1) und der zweiten (2) elektrisch leitenden Textilschicht mit leitendem Material beschichtet ist, wobei die Beschichtung aus leitendem Metall- und/oder Kohlenstoff- und/oder Polymermaterial ausgewählt ist, vorzugsweise Silber, Kohlenstoff oder Poly(3,4-ethylendioxythiophen)polystyrolsulfonat (PEDOT:PSS).

6. Energiegewinnungsvorrichtung nach einem der Ansprüche 1 bis 5, wobei die Schicht aus einem piezoelektrischen Polymerfilm (3) ein Material mit piezoelektrischen Eigenschaften umfasst, wobei das Material einen polarisierten Polyvinylidenfluorid-(PVDF-) Film und/oder einen modifizierten polarisierten PVDF-Film umfasst.

7. Energiegewinnungsvorrichtung nach Anspruch 6, wobei das piezoelektrische Material der piezoelektrischen Polymerfilmschicht (3) mit leitenden Schichten beschichtet ist, die auf Metall oder einem leitenden Polymer basieren, vorzugsweise mit Kohlenstoff, Silber und Poly(3,4-ethylendioxythiophen)polystyrolsulfonat.

8. Sensor, der eine Energiegewinnungsvorrichtung nach einem der Ansprüche 1 bis 7 umfasst.

9. Verfahren zur Herstellung einer Energiegewinnungsvorrichtung und eines Sensors, das die folgenden Schritte umfasst:
• Herstellen einer ersten (1) und zweiten (2) elektrisch leitenden Textilschicht durch entweder Beschichten einer Textilie oder eines Vlieses mit leitendem Material oder Herstellen einer gestrickten oder Stickstruktur mit einem leitenden Faden,
• Aktivieren einer piezoelektrischen Polymerfilmschicht (3) mit Plasma,
• Laminieren der piezoelektrischen Polymerfilmschicht (3) zwischen der ersten (1) und der zweiten (2) elektrisch leitenden Schicht, wobei die piezoelektrische Polymerfilmschicht (3) vor dem Laminierungsvorgang polarisiert wird,
• und Integrieren einer Gleichrichtungsschaltung in die Vorrichtung.

10. Verfahren nach Anspruch 9, wobei die Temperatur im Laminierungsvorgang der piezoelektrischen Polymerfilmschicht (3) zwischen der ersten (1) und der zweiten (2) elektrisch leitenden Textilschicht im Bereich von 70 bis 190 °C, vorzugsweise 80 bis 170 °C, liegt, wobei der Druck im Laminierungsvorgang 1 bis 40 N, vorzugsweise 30 bis 40 N, beträgt, wobei der Energieeintrag 0,5 bis 3 kW, vorzugsweise 1 bis 2 kW beträgt.

11. Verfahren nach Anspruch 9 oder Anspruch 10, wobei die Aktivierung mit einem Niederdruckplasma erfolgt, wobei mit sauerstoffhältigen funktionellen Gruppen unter Verwendung eines Gemischs aus Argon und molekularem Sauerstoff in einem Verhältnis von 1 zu 4 aktiviert wird, wobei der Druck des Plasmas vorzugsweise zwischen 0,1 und 0,5 mbar beträgt, wobei die Expositionsdauer vorzugsweise zwischen 30 und 600 s beträgt.

## Revendications

1. Dispositif de collecte d'énergie, comprenant :
- une première couche (1) de matériau textile électriquement conducteur,
- une seconde couche (2) de matériau textile électriquement conducteur,
- une couche de film polymère piézoélectrique (3) agencée entre la première (1) et la seconde (2) couches textiles électriquement conductrices,
dans lequel la couche de film polymère piézoélectrique (3) est stratifiée entre la première (1) et la seconde (2) couche textile électriquement conductrice en utilisant une couche extérieure de polyuréthane (PU) de protection.

2. Dispositif de collecte d'énergie selon la revendication 1, **caractérisé en ce que** la couche de film polymère piézoélectrique (3) est polarisée.

3. Dispositif de collecte d'énergie selon la revendication 1 ou 2, dans lequel la couche de film polymère piézoélectrique (3) est traitée au plasma.

4. Dispositif de collecte d'énergie selon l'une quelconque des revendications 1 à 3, dans lequel les première (1) et seconde (2) couches textiles électriquement conductrices comprennent tout tissu 2D ou 3D réalisé en fibres naturelles ou en fibres synthétiques avec une structure tissée, tricotée, brodée ou non tissée.

5. Dispositif de collecte d'énergie selon la revendication 4, dans lequel le matériau naturel ou synthétique des première (1) et seconde (2) couches textiles électriquement conductrices est revêtu d'un matériau conducteur, dans lequel le revêtement est choisi parmi un matériau conducteur métallique et/ou en carbone et/ou polymère, de préférence en argent, en carbone ou en poly(3,4-éthylènedioxythiophène)-polystyrène sulfonate (PEDOT :PSS).

6. Dispositif de collecte d'énergie selon l'une quelconque des revendications 1 à 5, dans lequel la couche de film de polymère piézoélectrique (3) comprend un matériau avec des propriétés piézoélectriques, dans lequel le matériau comprend un film de poly(fluorure de vinylidène) polarisé (PVDF) et/ou un film de PVDF polarisé modifié.

7. Dispositif de collecte d'énergie selon la revendication 6, dans lequel le matériau piézoélectrique de la couche de film polymère piézoélectrique (3) est revêtu de couches conductrices à base de métal ou de polymère conducteur, de préférence de carbone, d'argent et de poly(3,4-éthylènedioxythiophène)-polystyrène sulfonate.

8. Capteur comprenant un dispositif de collecte d'énergie selon l'une quelconque des revendications 1 à 7.

9. Procédé de fabrication d'un dispositif de collecte d'énergie et capteur comprenant les étapes consistant à
• préparer une première (1) et une seconde (2) couche textile électriquement conductrice en enduisant un textile ou un non-tissé de matériau conducteur ou en produisant une structure tricotée ou brodée avec un fil conducteur,
• activer une couche de film polymère piézoélectrique (3) avec du plasma,
• stratifier la couche de film polymère piézoélectrique (3) entre la première (1) et la seconde (2) couche électriquement conductrice, dans lequel la couche de film polymère piézoélectrique (3) est polarisée avant le processus de stratification
• et intégrer un circuit de redressement dans le dispositif

10. Procédé selon la revendication 9, dans lequel la température dans le processus de stratification de la couche de film polymère piézoélectrique (3) entre la première (1) et la seconde (2) couche textile électriquement conductrice est dans la plage de 70 à 190°C, de préférence de 80 à 170°C, dans lequel la pression dans le processus de stratification est de 1 à 40 N, de préférence de 30 à 40 N, dans lequel l'entrée d'énergie est de 0,5 à 3 kW, de préférence de 1 à 2 kW.

11. Procédé selon la revendication 9 ou la revendication 10, dans lequel l'activation est effectuée avec un plasma à basse pression, dans lequel il est activé avec des groupes fonctionnels contenant de l'oxygène en utilisant un mélange d'argon et d'oxygène moléculaire dans un rapport de 1 à 4, dans lequel la pression du plasma est de préférence comprise entre 0,1 et 0,5 mbar, dans lequel le temps d'exposition est de préférence compris entre 30 et 600 s.
